# EUROPÄISCHE PATENTANMELDUNG

(11) **EP 0 890 932 A1**
(43) Veröffentlichungstag der Anmeldung: **13.01.1999**
(21) Anmeldenummer: 97111609.0
(22) Anmeldetag: 09.07.1997
(51) Int. Cl.: G08B 29/18, H03M 1/10

(54) **Verfahren zur Verarbeitung der Sensorsignale eines Gefahrenmelders und Signalauswertungsschaltung zur Durchführung des Verfahrens**

(71) Anmelder: CERBERUS AG, CH-8708 Männedorf (CH)
(72) Erfinder: Hess, Kurt, Dr., 8633 Wolfhausen (CH)

(57) **Zusammenfassung**

Das unverstärkte Sensorsignal (I_{f}) wird mit einem Referenzsignal (Iᵣ) verglichen, wobei bei jedem Vergleich eine Bestimmung des überwiegenden Signals erfolgt und anhand des Ergebnisses dieser Bestimmung entschieden wird, ob eine Gefahrenstufe erreicht ist. Die Signalauswertungsschaltung enthält einen Mikroprozessor (1) und durch einen an den Port-Ausgang des Mikroprozessors (1) angeschlossenen Mehrfach-Spannungsteiler (3) und einen diesem nachgeschalteten Serienwiderstand (4) gebildete Mittel zur Erzeugung des Referenzstroms (Iᵣ) und durch einen Komparator (5) gebildete Mittel zum Vergleich des Sensorsignals (I_{f}) mit dem Referenzstrom (Iᵣ). Der Eingang des Komparators (5) ist mit dem Sensorsignal (I_{f}) und dem Referenzstrom (Iᵣ) beaufschlagt und der Ausgang des Komparators (5) ist mit einem Eingang des Mikroprozessors (1) verbunden.

Wahlweise wird mit dem Referenzstrom (Iᵣ) eine Referenzladung (Cᵣ) erzeugt, welche durch das Sensorsignal (I_{f}) entladen wird, und es wird anhand des Grades der Entladung entschieden, ob eine Gefahrenstufe erreicht ist.

## Beschreibung

Die vorliegende Erfindung betrifft ein Verfahren zur Verarbeitung der Sensorsignale eines einen Sensor für eine zu überwachende Gefahrenkenngrösse aufweisenden Gefahrenmelders.

Derartige Gefahrenmelder können beispielsweise einen Wärmesensor enthaltende thermische Melder oder eine Lichtquelle, eine Messkammer und einen Lichtempfänger aufweisende Streulichtrauchmelder zur Früherkernung Von Bränden sein, wobei die zu überwachende Gefahrenkenngrösse im ersten Fall die Temperatur im Überwachungsraum und im zweiten Fall das vom Lichtempfänger des Melders empfangene Streulicht aus der Messkammer ist.

Die Rauchdetektion durch Streulichtrauchmelder beruht bekanntlich darauf, dass Lichtquelle und Lichtempfänger so angeordnet sind, dass keine Lichtstrahlen auf direktem Weg von der Lichtquelle zum Empfänger gelangen können, und dass bei Anwesenheit von Rauchpartikeln in der Messkammer das Licht der Lichtquelle an diesen gestreut wird, wobei ein Teil dieses gestreuten Lichts auf den Lichtempfänger fällt und ein elektrisches Signal bewirkt. Dieses elektrische Signal wird verstärkt und in einem Analog-/Digitalwandler digitalisiert. Dann wird am Ausgang des A/D-Wandlers ein Byte gebildet und dieses wird mit einem Schwellenwert verglichen.

In dieser Schaltung bilden der Verstärker und der A/D-Wandler relativ teure Komponenten, die den Preis des Melders negativ beeinflussen. Durch die Erfindung soll nun ein Verfahren zur Verarbeitung der Sensorsignale angegeben werden, dessen Durchführung mit einer wesentlich einfacheren und deutlich kostengünstigeren Schaltung als bisher möglich ist.

Die gestellte Aufgabe wird erfindungsgemäss dadurch gelöst, dass ein Referenzsignal erzeugt und das unverstärkte Sensorsignal mit diesem verglichen wird, und dass bei jedem Vergleich eine Bestimmung des überwiegenden Signals erfolgt und anhand des Ergebnisses dieser Bestimmung entschieden wird, ob eine Gefahrenstufe erreicht ist.

Beim erfindungsgemässen Verfahren wird also nicht so wie bisher das Sensorsignal verstärkt, digitalisiert und mit einem digitalen Wort verglichen, sondern es erfolgt lediglich ein Vergleich zwischen zwei Signalen, dem Sensorsignal und dem Referenzsignal. Das ergibt eine wesentliche Vereinfachung der für die Verarbeitung der Sensorsignale erforderlichen Schaltung und eine deutliche Reduktion von deren Kosten. Insbesondere sinkt sowohl der Strom- als auch der Zeitbedarf, und es ist keine Abtast-Halte-Schaltung erforderlich.

Eine erste bevorzugte Ausführungsform des erfindungsgemässen Verfahrens ist dadurch gekennzeichnet, dass ein Referenzstrom erzeugt und das Sensorsignal direkt mit diesem verglichen wird.

Eine Zweite bevorzugte Ausführungsform ist dadurch gekennzeichnet, dass ein Referenzstrom erzeugt und aus diesem eine Referenzladung gewonnen wird, und dass die Referenzladung durch das Sensorsignal entladen und anhand des Grades der Entladung entschieden wird, ob eine Gefahrenstufe erreicht ist.

Eine dritte bevorzugte Ausführungsform der erfindungsgemässen Verfahrens ist dadurch gekennzeichnet, dass die Zeitdauer für die vollständige Entladung der Referenzladung durch das Sensorsignal gemessen und daraus die Grösse des Sensorsignals bestimmt wird.

Bei der ersten und der Zweiten bevorzugten Ausführungsform erhält man aus dem Vergleich des Sensorsignals mit dem Referenzstrom bzw. der Referenzladung einen binären Wert, der anzeigt, ob das Sensorsignal überwiegt und gegebenenfalls Alarm auszulösen ist. Bei der dritten bevorzugten Ansführungsform erhalt man einen Analogwert, der die Grösse des Sensorsignals angibt.

Die Erfindung betrifft weiter eine Signalauswertungsschaltung mit einem Mikroprozessor zur Durchführung des genannten Verfahrens.

Die erfindungsgemässe Schaltung ist dadurch gekennzeichnet, dass Mittel zur Erzeugung eines Referenzstroms und Mittel zum Vergleich des Sensorsignals mit diesem Referenzstrom vorgesehen sind.

Eine erste bevorzugte Ausführungsform der erfindungsgemässen Schaltung ist gekennzeichnet durch Mittel zur Erzeugung einer Referenzladung aus dem Referenzstrom, wobei die Schaltung so ausgebildet ist, dass eine Entladung der Referenzladung durch das Sensorsignal erfolgt.

Eine Zweite bevorzugte Ausführungsform der erfindungsgemässen Schaltung ist gekennzeichnet durch Mittel zur Bestimmung der für die Entladung der Referenzladung durch das Sensorsignal erforderlichen Zeit.

Eine dritte bevorzugte Ausführungsform der erfindungsgemässen Schaltung ist dadurch gekennzeichnet, dass die genannten Mittel zur Erzeugung des Referenzstroms durch einen an den Port-Ausgang des Mikroprozessors angeschlossenen Mehrfach-Spannungsteiler und einen diesem nachgeschalteten Serienwiderstand gebildet sind, an dessen Ausgang ein mittels des Port-Ausgangs des Mikroprozessors programmierbarer Referenzstrom erhältlich ist.

Eine vierte bevorzugte Ausführungsform der erfindungsgemässen Schaltung ist dadurch gekennzeichnet, dass die genannten Mittel zum Vergleich des Sensorsignals mit dem Referenzstrom durch einen Komparator gebildet sind, dessen Eingang mit dem Sensorsignal und dem Referenzstrom beaufschlagt beziehungsweise an den Ausgang der Mittel zur Erzeugung der Referenzladung angeschlossen und dessen Ausgang mit einem digitalen Eingang des Mikroprozessors verbunden ist.

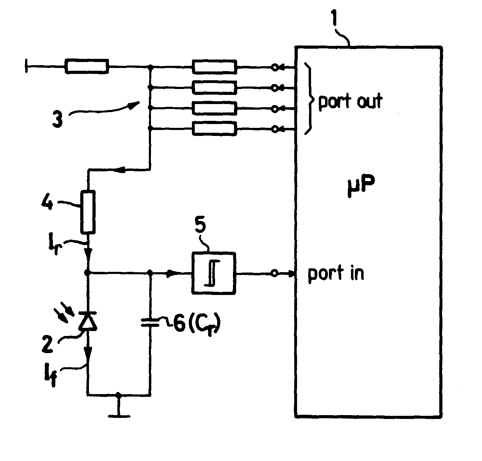

Im folgenden wird die Erfindung anhand eines Ausführungsbeispiels und der einzigen Zeichnung naher erläutert; die Zeichnung zeigt ein Blockschaltbild einer erfindungsgemässen Signalauswertungsschaltung für einen Rauchmelder.

Die dargestellte Schaltung, die unter anderem einen Mikroprozessor 1 enthält, dient zur Auswertung der Sensorsignale eines Streulichtrauchmelders, dessen Sensor eine Lichtquelle, eine Messkammer und einen Lichtempfänger aufweist. Der letztere ist beispielsweise durch eine Fotodiode 2 gebildet. Die Lichtquelle sendet kurze, intensive Lichtpulse in die Messkammer, aus welcher die Fotodiode 2 kein direktes sondern nur an in der Messkammer vorhandenen Rauchpartikeln gestreutes Licht empfängt. Dieser Melderaufbau ist bekannt und wird hier nicht näher beschrieben. Es wird in diesem Zusammenhang auf die europäische Patentanmeldung Nr. 96111751.2 verwiesen.

Die Menge des auf die Fotodiode 1 gelangenden Streulichts und somit der von der Fotodiode erzeugte Fotostrom I_{f} ist ein Mass für Anzahl und/oder Grösse der jeweils in der Messkammer vorhandenen Rauchpartikel. Dieser Fotostrom wird mit einem eine Gefahrenstufe repräsentierenden Referenzwert verglichen, und bei Übersteigen des Referenzwerts durch den Fotostrom wird in der Auswertungsschaltung ein Alarmsignal erzeugt.

Die Auswertung des Fotostroms der Fotodiode 2 ist bisher so erfolgt, dass der Fotostrom zuerst verstärkt und anschliessend digitalisiert, und dass aus dem digitalisierten Wert des Fotostroms ein digitales Wort, ein Byte, gebildet und mit einem Schwellenwert verglichen wurde. Abgesehen davon, dass der Verstärker und der A/D-Wandler relativ teure Komponenten sind, erfordert dieses Auswertungsverfahren relativ viel Zeit und Strom und eine spezielle Abtast-Halte-Schaltung.

Darstellungsgemäss enthält die Auswertungsschaltung einen an den Fort-Ausgang des Mikroprozessors 1 angeschlossenen Spannungsteiler 3, der eine Mehrzahl verschieden grosser, zuschaltbarer Widerstände aufweist, so dass je nach Wahl der Widerstände genaue und fein abgestufte Spannungswerte erhältlich sind. Die Anzahl dieser Spannungswerte richtet sich nach der Bitbreite am Fort-Ausgang. Der Spannungsteiler 3 wirkt wie ein Digital-/Analog-Wandler; er wandelt also das digitale Wort am Fort-Ausgang des Mikroprozessors 1 in eine Spannung um.

Die Spannungswerte gelangen an einen Serienwiderstand 4 und von diesem als Referenzstrom Iᵣ zu einem an die Fotodiode 2 angeschlossenen und mit dem Fotostrom I_{f} beaufschlagten Komparator 5, der entscheidet, welcher der beiden Ströme I_{f} oder Iᵣ überwiegt. Parallel zur Fotodiode 1 ist eine für die erforderliche Trägheit nötige Kapazität 6 angeordnet. Der Ausgang des Komparators 5 ist mit einem digitalen Eingang des Mikro-prozessors 1 verbunden.

Wie schon erwähnt wurde, sind die Widerstände des Spannungsteilers 3 so gewählt, dass am Serienwiderstand 4 der gewünschte Referenzstrom Iᵣ erhältlich ist. Wenn der Spannungsteiler 3 schon mehrere Widerstände aufweist, dann können diese auch dazu verwendet werden, verschiedene Referenzströme zu erzeugen, die verschiedenen Gefahrenstufen, beispielsweise einem Voralarm und einem Alarm, entsprechen.

Die durch die dargestellte Ausbildung des Spannungsteilers 3 mögliche fein abgestufte Einstellbarkeit des Referenzstroms Iᵣ ermöglicht eine einfache Nachführung des Sensors, oder mit anderen Worten, eine Kompensation sehr langsamer Änderungen, wie sie beispielsweise durch Verstaubung oder Alterung auftreten. Diese Nachführung wird dadurch realisiert, dass in bestimmten Zeitabständen das aktuelle Sensorsignal mit einem im Mikroprozessor 1 gespeicherten Nachführwert verglichen wird. Ergibt dieser Vergleich eine Differenz Zwischen dem aktuellen Sensorsignal und dem Nachführwert, dann wird der letztere geringfügig nachgeführt und somit dem aktuellen Sensorsignal nur sehr langsam angepasst. Das Gefahrensignal ist also gleich der Differenz von Messignal (Sensorsignal) und Nachführwert. Bei schnellen Ereignissen, wie beispielsweise beim Auftreten von Rauch, kann der Nachführwert dem aktuellen Sensorsignal nicht ausreichend rasch folgen, so dass Gefahrensituationen in jedem Fall rasch und sichererkannt werden.

Vom Ausgang des Komparators 5 gelangt ein binäres Signal in den Mikroprozessor 1, welches anzeigt, ob der Fotostrom I_{f} oder der Referenzstrom Iᵣ überwiegt, wobei ein Überwiegen des Fotostroms I_{f} auf eine Gefahrensituation hinweist. Wenn beispielsweise zwei unterschiedliche Referenzströme zur Verfügung stehen, kann der eine einem ersten Schwellenwert "Voralarm" und der andere einem Zweiten Schwellenwert "Alarm" zugeordnet sein.

Eine erste Variante des beschriebenen Verfahrens besteht darin, die Schwelle oder Schwellen nicht durch die Grösse des Referenzstroms Iᵣ sondern durch die zeitliche Dauer der Referenzstrompulse einzustellen. Bei dieser Variante kann der Spannungsteiler 3 vereinfacht und auf beispielweise zwei Widerstände reduziert werden.

Der Mikroprozessor 1 schickt unmittelbar vor jedem Lichtpuls des Lichtsenders (Fotostrom I_{f}) des Sensors einen Spannungspuls zum Spannungsteiler, dessen Dauer durch den Mikroprozessor regelbar ist. Der am Serienwiderstand 4 erhältliche Referenzstrompuls (Referenzstrom Iᵣ) lädt die Kapazität 6 auf eine Referenzladung Cᵣ auf, welche während des Lichtpulses des Lichtsenders von der Fotodiode 2 wieder entladen wird. Der Komparator 5 stellt fest, ob die Referenzladung Cᵣ durch den Fotostrom I_{f} vollständig entladen wird oder nicht und bestimmt also auch bei dieser Variante, welches der beiden Signale I_{f} oder Iᵣ überwiegt. Wenn nach der Entladephase die Ladung der Kapazität 6 grösser als null ist, dann liegt der Fotostrom I_{f} unterhalb der jeweiligen Gefahrenschwelle und es liegt keine Gefahrensituation vor. Ist die Ladung der Kapazität 6 nach der Entladephase gleich null, dann liegt der Fotostrom I_{f} oberhalb der betreffenden Gefahrenschwelle und es wird die erforderliche Aktion ausgelöst. Die Regelung der Dauer des vom Mikroprozessor abgegebenen Spannungspulses ist so gewählt, dass die durch den Referenzstrompuls in der Kapazität 6 gespeicherte Referenzladung Cᵣ der gewünschten Schwelle entspricht. Der Komparator 5 liefert an den Mikroprozessor 1 ein binäres Signal "Schwelle erreicht" oder "Schwelle nicht erreicht".

Diese Variante hat den Vorteil, dass mit der Dauer oder Länge der Referenzstrompulse die Schwelle ohne jede zusätzliche Hardware fein abgestuft vorgegeben werden kann, da die Kapazität 6 ohnehin für die erforderliche Trägheit benötigt wird.

Bei einer Zweiten Variante des beschriebenen Verfahrens zur Verarbeitung der Sensorsignale wird ebenfalls die Kapazität 6 durch einen unmittelbar vorjedem Lichtpuls I_{f} des Lichtsenders erzeugten Referenzstrompuls Iᵣ geladen und dadurch eine Referenzladung Cᵣ erzeugt, und diese Referenzladung wird anschliessend durch den Lichtpuls I_{f} entladen.

Im Unterschied zur ersten Variante stellt der Komparator 5 nicht nur fest, ob die Referenzladung Cᵣ durch den Fotostrom I_{f} vollständig entladen wird oder nicht, sondern er registriert im Fall einer vollständigen Entladung auch deren Zeitpunkt und meldet diesen an den Mikroprozessor 1. Dieser kennt den Zeitpunkt des Beginns der Entladung (Auslösung des Lichtpulses I_{f}) und kann über seinen internen Timer die Entladezeit bestimmen. Diese ist zur Grösse des Lichtpulses I_{f} indirekt proportional. Aus der Entladezeit kann unmittelbar die Grösse des Lichtpulses I_{f} betimmt werden. Somit erhält man bei dieser zweiten Variante nicht nur ein binäres Signal "Schwelle überschritten" oder "Schwelle nicht überschritten", sondern zusätzlich noch einen Analogwert für die Grösse des Lichtpulses oder Fotostroms I_{f}.

Wenn auch das erfindungsgemässe Verfahren zur Verarbeitung von Sensorsignalen anhand eines Streulichtrauchmelders beschrieben wurde, so ist es nicht auf diesen Meldertyp beschränkt, sondern kann in allen Gefahrenmeldern verwendet werden, in denen das Sensorsignal mit einem Schwellenwert verglichen wird. Melder dieser Art sind beispielsweise thermische Brandmelder oder Intrusionsmelder.

## Patentansprüche

1. Verfahren zur Verarbeitung der Sensorsignale eines einen Sensor für eine zu überwachende Gefahrenkenngrösse aufweisenden Gefahrenmelders, dadurch gekennzeichnet, dass ein Referenzsignal (Iᵣ) erzeugt und das unverstärkte Sensorsignal (I_{f}) mit diesem verglichen wird, und dass bei jedem Vergleich eine Bestimmung des überwiegenden Signals erfolgt und anhand des Ergebnisses dieser Bestimmung entschieden wird, ob eine Gefahrenstufe erreicht ist.

2. Verfahren nach Anspruch 1, dadurch gekennzeichnet, dass ein Referenzstrom (Iᵣ) erzeugt und das Sensorsignal (I_{f}) direkt mit diesem verglichen wird.

3. Verfahren nach Anspruch 1, dadurch gekennzeichnet, dass ein Referenzstrom (Iᵣ) erzeugt und aus diesem eine Referenzladung (Cᵣ) gewonnen wird, und dass die Referenzladung (Cᵣ) durch das Sensorsignal (I_{f}) entladen und anhand des Grades der Entladung entschieden wird, ob eine Gefahrenstufe erreicht ist.

4. Verfahren nach Anspruch 3, dadurch gekennzeichnet, dass die Zeitdauer für die vollständige Entladung der Referenzladung (Cᵣ) durch das Sensorsignal (I_{f}) gemessen und daraus die Grösse des Sensorsignals (I_{f}) bestimmt wird.

5. Verfahren nach einem der Ansprüche 1 bis 4, dadurch gekennzeichnet, dass in Abständen ein Vergleich des Sensorsignals (I_{f}) mit einem gespeicherten Nachführwert erfolgt, und dass bei Vorliegen einer Differenz der Nachführwert dem Sensorsignal (I_{f}) geringfügig angepasst wird.

6. Signalauswertungsschaltung mit einem Mikroprozessor zur Durchführung des Verfahrens nach einem der Ansprüche 1 bis 5, dadurch gekennzeichnet, dass Mittel (3, 4) zur Erzeugung eines Referenzstroms (Iᵣ) und Mittel (5) zum Vergleich des Sensorsignals (I_{f}) mit diesem Referenzstrom (Iᵣ) vorgesehen sind.

7. Signalauswertungsschaltung nach Anspruch 6, gekennzeichnet durch Mittel (6) zur Erzeugung einer Referenzladung (Cᵣ) aus dem Referenzstrom (Iᵣ), wobei die Schaltung so ausgebildet ist, dass eine Entladung der Referenzladung (Cᵣ) durch das Sensorsignal (I_{f}) erfolgt.

8. Signalauswertungsschaltung nach Anspruch 7 gekennzeichnet durch Mittel zur Bestimmung der für die Entladung der Referenzladung (Cᵣ) durch das Sensorsignal (I_{f}) erforderlichen Zeit.

9. Signalauswertungsschaltung nach einem der Ansprüche 6 bis 8, dadurch gekennzeichnet, dass die genannten Mittel zur Erzeugung des Referenzstroms (Iᵣ) durch einen an den Port-Ausgang des Mikroprozessors (1) angeschlossenen Mehrfach-Spannungsteiler (3) und einen diesem nachgeschalteten Serienwiderstand (4) gebildet sind, an dessen Ausgang ein mittels des Port-Ausgangs des Mikroprozessors (1) programmierbarer Referenzstrom (Iᵣ) erhältlich ist.

10. Signalauswertungsschaltung nach Anspruch 7 oder 8, dadurch gekennzeichnet, dass die genannten Mittel zur Erzeugung des Referenzstroms (Iᵣ) durch einen an den Port-Ausgang des Mikroprozessors (1) angeschlossenen Spannungsteiler (3) und einen Serienwiderstand (4) und eine diesem nachgeschaltete Kapazität (6) zur Erzeugung der Referenzladung (Cᵣ) gebildet sind, und dass der Spannungsteiler (3) vom Mikroprozessor (1) mit Spannungspulsen wählbarer Dauer beaufschlagbar ist.

11. Signalauswertungsschaltung nach Anspruch 9 oder 10, dadurch gekennzeichnet, dass die genannten Mittel zum Vergleich des Sensorsignals (I_{f}) mit dem Referenzstrom (Iᵣ) durch einen Komparator (5) gebildet sind, dessen Eingang mit dem Sensorsignal (I_{f}) und dem Referenzstrom (Iᵣ) beaufschlagt beziehungsweise an den Ausgang der Mittel (6) zur Erzeugung der Referenzladung (Cᵣ) angeschlossen und dessen Ausgang mit einem digitalen Eingang des Mikroprozessors (1) verbunden ist.

12. Signalauswertungsschaltung nach Anspruch 9, dadurch gekennzeichnet, dass der Spannungsteiler (3) eine Mehrzahl zuschaltbarer Widerstände aufweist, so dass am Ausgang des Serienwiderstands (4) eine wählbare Anzahl von verschiedenen Gefahrenstufen zugeordneten Referenzströmen (Iᵣ) erhältlich ist.

13. Signalauswertungsschaltung nach den Ansprüchen 8 und 11, dadurch gekennzeichnet, dass die genannten Mittel zur Bestimmung der Entladungszeit der Referenzladung (Cᵣ) durch den internen Timer des Mikroprozessors (1) gebildet sind.

14. Signalauswertungsschaltung nach einem der Ansprüche 6 bis 8, dadurch gekennzeichnet, dass die Speicherung des Nachführwerts im Mikroprozessor (1) erfolgt.
